# EUROPÄISCHE PATENTSCHRIFT

(11) **EP 2 369 034 B1**
(45) Veröffentlichungstag und Bekanntmachung des Hinweises auf die Patenterteilung: **30.01.2013**
(21) Anmeldenummer: 10157914.2
(22) Anmeldetag: 26.03.2010
(51) Int. Cl.: C23C 14/24

(54) **Verfahren zum Nachfüllen einer Selenverdampferkammer**
Method for refilling a selenium evaporation chamber
Procédé de remplissage d'une chambre d'évaporateur de sélénium

(43) Veröffentlichungstag der Anmeldung: 28.09.2011
(73) Patentinhaber: Saint-Gobain Glass France, 92400 Courbevoie (FR)
(72) Erfinder: Boger, Raimund, 89231 Neu-Ulm (DE); Götze, Thomas, 04886, Großtreben (DE); Jahnke, Andreas, 81827, München (DE)
(74) Vertreter: Lendvai, Tomas

(56) Entgegenhaltungen:
- EP-A1- 2 025 773
- JP-A- 2008 248 362

## Beschreibung

Die Erfindung betrifft ein Verfahren und eine Vorrichtung zum Nachfüllen einer Selenverdampferkammer, insbesondere zum diskontinuierlichen Nachfüllen der Selenverdampferkammer.

Einer der Vorteile von Dünnschichtsolarzellen gegenüber Solarzellen mit kristallinen oder polykristallinen Silizium ist ihre große Flexibilität im Hinblick auf das verwendete Substrat und die Größe des zu beschichtenden Substrats. So lassen sich Dünnschichtsolarzellen auch großflächig auf Glasscheiben oder auf flexiblen Materialien, wie beispielsweise Kunststoffen herstellen.

Photovoltaische Schichtsysteme zur direkten Umwandlung von Sonnenstrahlung in elektrische Energie sind hinreichend bekannt. Die Materialien und die Anordnung der Schichten sind so abgestimmt, dass einfallende Strahlung von einer oder mehreren halbleitenden Schichten mit möglichst hoher Strahlungsausbeute direkt in elektrischen Strom umgewandelt wird. Photovoltaische und flächig ausgedehnte Schichtsysteme werden als Solarzellen bezeichnet.

Solarzellen enthalten in allen Fällen Halbleitermaterial. Solarzellen, die zur Bereitstellung einer ausreichenden mechanischen Festigkeit Trägersubstrate benötigen, werden als Dünnschichtsolarzellen bezeichnet. Aufgrund der physikalischen Eigenschaften und der technologischen Handhabbarkeit sind Dünnschichtsysteme mit amorphen, mikromorphen oder polykristallinen Silizium, Cadmium-Tellurid (CdTe), Gallium-Arsenid (GaAs) oder Kupfer-Indium(Gallium)-Schwefel/Selen (CI(G)S) besonders für Solarzellen geeignet.

Bekannte Trägersubstrate für Dünnschichtsolarzellen enthalten anorganisches Glas, Polymere oder Metalllegierungen und können in Abhängigkeit von Schichtdicke und Materialeigenschaften als starre Platten oder biegsame Folien ausgestaltet sein. Aufgrund der weitreichend verfügbaren Trägersubstrate und einer einfachen monolithischen Integration können großflächige Anordnungen von Dünnschichtsolarzellen kostengünstig hergestellt werden.

Dünnschichtsolarzellen zeigen allerdings im Vergleich zu Solarzellen mit kristallinen oder multikristallinen Silizium eine geringere Strahlungsausbeute und einen geringeren elektrischen Wirkungsgrad. Dünnschichtsolarzellen basierend auf Cu(In, Ga)(S, Se)₂ zeigen elektrische Wirkungsgrade, die annährend mit multikristallinen Silizium-Solarzellen vergleichbar sind. CI(G)S-Dünnschichtsolarzellen benötigen eine Pufferschicht zwischen typisch p-leitendem CI(G)S-Absorber und typisch n-leitender Frontelektrode, die üblicherweise Zinkoxid (ZnO) umfasst. Die Pufferschicht kann eine elektronische Anpassung zwischen Absorbermaterial und Frontelektrode bewirken. Die Pufferschicht enthält beispielsweise eine Cadmium-Schwefel-Verbindung. Eine Rückelektrode mit beispielsweise Molybdän wird direkt auf Trägersubstraten abgeschieden.

Eine elektrische Schaltung von mehreren Solarzellen wird als Photovoltaik- oder Solarmodul bezeichnet. Die Schaltung von Solarzellen wird in bekannten witterungsstabilen Aufbauten dauerhaft vor Umwelteinflüssen geschützt. Üblicherweise sind eisenarme Natron-Kalk-Gläser und haftvermittelnde Polymerfolien mit den Solarzellen zu einem bewitterungsstabilen Photovoltaikmodul verbunden. Die Photovoltaikmodule können über Anschlussdosen in eine Schaltung von mehreren Photovoltaikmodulen eingebunden sein. Die Schaltung von Photovoltaikmodulen ist über bekannte Leistungselektronik mit dem öffentlichen Versorgungsnetz oder einer autarken elektrischen Energieversorgung verbunden.

Die Abscheidung von Selen, insbesondere bei der sequenziellen Abscheidung der Komponenten der CIS-Schicht, erfordert in der Regel ein Vakuum. Dies bedingt eine vollständige Unterbrechung des Prozesses wenn das zur Abscheidung vorgesehene Selen aufgebraucht ist. Die gesamte Apparatur muss belüftet, abgekühlt, Selen in die Apparatur nachgefüllt und anschließend wieder evakuiert und erwärmt werden. Diese Schritte sind sehr zeitaufwendig und bei einer großtechnischen Produktion sehr kostenintensiv, da der Verdampfungsprozess jeweils für einen längeren Zeitraum unterbrochen wird. Durch diese notwendigen Schritte, insbesondere die Belüftungs-und Abkühlprozesse, ist eine kontinuierliche Selenbedampfung nicht möglich. Da die Größe der Verdampfungsvorrichtung und die Selendampfkonzentration wichtige Prozessparameter sind, kann zudem nicht beliebig viel Selen in die Selenverdampferkammer eingebracht werden. Zudem ist die Geschwindigkeit einer gleichmäßigen Selenverdampfung auch von einem definierten Oberfläche- zu Volumenverhältnis des zu verdampfenden Selens abhängig.

WO 2007/077171 A2 offenbart ein Verfahren zur Herstellung von Chalkopyritschichten in CIGSS - Solarzellen. Dazu wird ein Substrat mit Precursorn beschichtet und zusammen mit Schwefel und Selen in eine dicht verschließbare Reaktionsbox gelegt. Die Reaktionsbox wird in einen RTP- Ofen gebracht, evakuiert und auf die notwendige Reaktionstemperatur erhitzt.

EP 0 715 358 A2 offenbart ein Verfahren zur Herstellung einer Solarzelle mit Chalkopyrit-Absorberschicht. Im Verfahren wird durch Zugabe von Na, K oder Li ein gewünschter Alkaligehalt eingestellt. Eine zusätzliche Diffusion von Alkaliionen aus dem Substrat wird durch eine Diffusionssperrschicht verhindert. Selen und/oder Schwefel werden im Verfahren zumindest teilweise über eine entsprechende Schwefel-oder Selenhaltige Atmosphäre zugeführt.

WO 2009/034131 A2 offenbart ein Verfahren zum Abscheiden von Chalkogenen in dünnen Schichten. Das Selen wird als Festkörper in einem Vorratsgefäß gelagert und von dort in eine Kammer überführt und verdampft. Die Kammer ist am Eingang mit einem Verschluss versehen um ein Entweichen der Selendämpfe in das Vorratsgefäß zu vermeiden.

US 4,880,960 A offenbart ein Verfahren zur Vakuum Verdampfung und eine Vorrichtung zur Beschichtung eines beweglichen Substrats. Das aufzutragende Material wird kontinuierlich aus einem Vorratsbehälter über ein Ventil in eine Vakuumkammer überführt, erhitzt und dort auf ein auf Rollen gelagertes Substrat aufgedampft. Die Erfindung offenbart die Bedampfung von Kohlefasern mit Magnesium.

WO 2009/010468 A1 offenbart eine Vorrichtung zum Verdampfen fester Materialien. Das feste Material, beispielsweise Selen, wird in einen ersten Tiegel gebracht und aufgeschmolzen. Das geschmolzene Material fließt über eine Transportvorrichtung in einen zweiten Tiegel. In diesem Tiegel wird das geschmolzene Material verdampft und auf ein Substrat gebracht. Das Einfüllen des Materials erfolgt in ein Reservoir, das nach dem Befüllen geschlossen, sowie anschließend evakuiert wird und über ein Ventil das feste Material zum ersten Tiegel durchlässt.

Die Aufgabe der vorliegenden Erfindung liegt darin, ein Verfahren bereitzustellen, das ein diskontinuierliches Nachfüllen einer Selenverdampferkammer ermöglicht, ohne die Selenverdampfung zu unterbrechen.

Die Aufgabe der vorliegenden Erfindung wird erfindungsgemäß durch ein Verfahren zum diskontinuierlichen Nachfüllen einer Selenverdampferkammer, einer Vorrichtung und deren Verwendung gemäß Anspruch 1 gelöst. Bevorzugte Ausführungen gehen aus den Unteransprüchen hervor.

Eine erfindungsgemäße Vorrichtung und deren Verwendung gehen aus weiteren Ansprüchen hervor.

Das erfindungsgemäße Verfahren zum Nachfüllen einer Selenverdampferkammer umfasst in einem ersten Schritt das Einfüllen von festem Selen über eine Zuführung durch einen gekühlten Vakuumschieber in ein mittleres Verbindungsstück. Der gekühlte Vakuumschieber wird auf 20 °C bis 45 °C temperiert. Die Temperierung des gekühlten Vakuumschiebers verhindert ein Verkleben des festen Selens beim Einfüllen. Ist die Selenzufuhr abgeschlossen, so wird der gekühlte Vakuumschieber geschlossen. In einem nächsten Schritt erfolgt das Anlegen eines Vakuums von 10⁻⁷ mbar bis 100 mbar, bevorzugt 0,1 mbar bis 10 mbar zwischen dem gekühlten Vakuumschieber, dem mittleren Verbindungsstück und einem an dem mittleren Verbindungsstück befestigten, geheizten Vakuumschieber. Der geheizte Vakuumschieber wird auf 130 °C bis 180 °C temperiert.

Die Temperierung des geheizten Vakuumschiebers, als auch des gekühlten Vakuumschieber kann am Bauteil selbst oder über die benachbarten Baugruppen erfolgen. Im folgenden Schritt wird das Selen in eine Selenverdampferkammer durch Öffnen des geheizten Vakuumschiebers überführt. Vor dem Öffnen des geheizten Vakuumschiebers kann das Vakuum im Raum aus dem gekühlten Vakuumschieber, dem mittleren Verbindungsstück und einem geheizten Vakuumschieber auf einen Wert von 10⁻² mbar und 10⁻⁶ mbar abgesenkt werden. Das Vakuum ist bevorzugt in beiden Räumen gleich, die Selenverdampferkammer weist bevorzugt ein Vakuum von 10⁻² mbar und 10⁻⁷ mbar auf. Die Temperierung des geheizten Vakuumschiebers auf 130 °C bis 180 °C verhindert ein Kondensieren der Selendämpfe beim Öffnen des geheizten Vakuumschiebers. In einem folgenden Schritt wird der geheizte Vakuumschieber wieder geschlossen. Nach einer erneuten Belüftung über den gekühlten Vakuumschieber kann bei Bedarf erneut Selen nachgefüllt werden.

Die Kühlung des gekühlten Vakuumschiebers erfolgt bevorzugt durch ein an dem gekühlten Vakuumschieber angebrachtes erstes gekühltes Verbindungsstück und/oder ein zweites gekühltes Verbindungsstück.

Der geheizte Vakuumschieber wird bevorzugt durch ein an dem Vakuumschieber angebrachtes drittes gekühltes Verbindungsstück und/oder ein erstes geheiztes Verbindungsstück temperiert.

Der gekühlte Vakuumschieber wird bevorzugt auf 25 °C bis 35 °C temperiert.

Der geheizte Vakuumschieber wird bevorzugt auf 150 °C bis 170°C temperiert.

Die Erfindung beinhaltet des Weiteren eine Vorrichtung zum diskontinuierlichen Nachfüllen einer Selenverdampferkammer. Die Vorrichtung umfasst mindestens eine Zuführung für festes Selen, beispielsweise einen Trichter. An der Zuführung ist ein gekühlter Vakuumschieber befestigt. Die Temperierung des gekühlten Vakuumschiebers kann durch auf oder an dem Vakuumschieber angeschlossene Kühlschläuche bzw. Kapillaren erfolgen. Die Kühlmedien können dabei sowohl flüssig, als auch gasförmig vorliegen, geeignete Kühlmedien sind beispielsweise Wasser, wässerige oder organische Kühlflüssigkeiten, Luft, Kohlendioxid oder Stickstoff. Die Kühlung ist bevorzugt im Bereich der Durchlassöffnung des gekühlten Vakuumschiebers angeordnet. An dem gekühlten Vakuumschieber ist ein mittleres Verbindungsstück angebracht. Ein geheizter Vakuumschieber schließt sich an das mittlere Verbindungsstück an. An dem geheizten Vakuumschieber ist eine Selenverdampferkammer angebracht und ermöglicht so das direkte Befüllen der Selenverdampferkammer mit Selen über die beschriebene Vorrichtung. Das mittlere Verbindungsstück weist bevorzugt Anschlüsse zum Anlegen eines Vakuums auf, alternativ kann das Vakuum auch durch Öffnen des geheizten Vakuumschiebers und somit Herstellung einer direkten Verbindung zur Selenverdampferkammer erzeugt werden. Die Verbindungsstücke, Vakuumschieber und die Zuführung sind bevorzugt aus Metallen, besonders bevorzugt Eisen, Chrom, Vanadium, Nickel, Kobalt, Titan, Aluminium, ganz besonders bevorzugt aus Stahl gefertigt. Die Dicke und die Wandstärke sind so bemessen, dass sie sowohl gegenüber den Temperaturschwankungen als auch dem Druckunterschied zwischen Atmosphärendruck und Vakuum in dem mittleren Verbindungsstück und der Selenverdampferkammer beständig sind. Die Verbindungsstücke können sowohl als Hohlkörper oder als Vollkörper mit einer Durchbohrung ausgebildet sein.

Die Vorrichtung zum diskontinuierlichen Nachfüllen einer Selenverdampferkammer beinhaltet bevorzugt eine Zuführung für festes Selen und ein an der Zuführung angebrachtes erstes gekühltes Verbindungsstück. An dem ersten gekühlten Verbindungsstück ist der gekühlte Vakuumschieber angebracht und an dem gekühlten Vakuumschieber ein zweites gekühltes Verbindungsstück befestigt. Die beiden gekühlten Verbindungsstücke temperieren den Innenbereich des gekühlten Vakuumschiebers bevorzugt auf eine Temperatur von 20 °C bis 45 °C. An dem zweiten gekühlten Verbindungsstück ist eine Anordnung aus mittlerem Verbindungsstück, dritten gekühlten Verbindungsstück, geheizter Vakuumschieber und ein erstes geheiztes Verbindungsstück angebracht. Das dritte gekühlte Verbindungsstück und das erste geheizte Verbindungsstück temperieren den geheizten Vakuumschieber bevorzugt auf 130 °C bis 180 °C. Die Selenverdampferkammer ist mit dem ersten geheizten Verbindungsstück verbunden.

Das erste gekühlte Verbindungsstück, zweite und/oder das dritte gekühlte Verbindungsstück enthalten bevorzugt eine Lochplatte mit Öffnung und eine Kühlung, ein mechanisches Gegenlager, einen Verschluss, eine Öffnung im Verschluss, einen Schieber und/oder ein Schiebergehäuse. Das Schiebergehäuse und der Schieber sind außen am ersten, zweiten und/oder dritten gekühlten Verbindungsstück angebracht. Der Schieber ist über eine Bohrung am Schiebergehäuse und gekühlten Verbindungsstück mit dem Innenraum der gekühlten Verbindungsstücke verbunden. Die Lochplatte und der Verschluss ermöglichen, abhängig von der Stellung des Schiebers, eine Durchlässigkeit oder Undurchlässigkeit für das Selen sowie ein Einstellen des Vakuums oder ein Belüften der benachbarten Verbindungstücke. Der Schieber ist bevorzugt direkt mit dem Verschluss verbunden. Befinden sich die Öffnung des Verschlusses und die Öffnung der Lochplatte deckungsgleich übereinander, so ist die Anordnung für das Selen durchlässig. Im anderen Fall, haben die Öffnung des Verschlusses und die Öffnung der Lochplatte keine gemeinsame Deckungsfläche, so ist die Anordnung für das Selen undurchlässig. Die Kühlung ist bevorzugt in Form einer Kühlschleife an der Lochplatte und/oder dem Verschluss, besonders bevorzugt umfänglich um die Öffnung der Lochplatte und/oder die Öffnung des Verschlusses angeordnet. Die Anordnung aus Lochplatte und Verschluss sind bevorzugt im 90° Winkel zur Einführrichtung des Selens angeordnet.

Das erste geheizte Verbindungsstück ist bevorzugt analog zu den oben beschriebenen gekühlten Verbindungsstücken aufgebaut. Die Heizung ist bevorzugt in Form einer elektrischen Widerstandsheizung an der Lochplatte und/oder dem Verschluss, besonders bevorzugt umfänglich um die Öffnung der Lochplatte und/oder der Öffnung des Verschlusses angeordnet.

Die Zuführung, das mittlere Verbindungsstück, das erste gekühlte Verbindungsstück, das zweite gekühlte Verbindungsstück, das dritte gekühlte Verbindungsstück und/oder das erste geheizte Verbindungsstück weisen bevorzugt einen durchgängigen zylindrischen Hohlraum mit einem Durchmesser von 20 mm bis 50 mm, besonders bevorzugt von 25 mm bis 45 mm, auf. Sie umfassen bevorzugt Kreutzstücke, bevorzugt Kreutzstücke mit einem durchgehenden zylindrischen Hohlraum. Sie weisen bevorzugt eine Breite und/oder Höhe von 150 mm bis 300 mm, bevorzugt 200 mm bis 250 mm auf.

Der geheizte Vakuumschieber und/oder gekühlte Vakuumschieber weisen bevorzugt eine Öffnung mit einem Durchmesser von 15 mm bis 50 mm, bevorzugt 30 mm bis 40 mm auf.

Die Öffnung im geheizten Vakuumschieber und/oder gekühlten Vakuumschieber ist bevorzugt von einer Heizung oder Kühlung umgeben. Die Heizung ist bevorzugt in Form einer elektrischen Widerstandsheizung, die Kühlung ist bevorzugt in Form einer Kühlschleife am Vakuumschieber angeordnet.

Die Erfindung umfasst des Weiteren die Verwendung der erfindungsgemäßen Vorrichtung zum diskontinuierlichen Nachfüllen einer Verdampferkammer für Schwefel, Selen, Tellur und/oder Gemischen davon. Die erfindungsgemäße Vorrichtung und das erfindungsgemäße Verfahren zum Nachfüllen einer Selenverdampferkammer eignen sich auch zum Nachfüllen einer Verdampferkammer der Elemente Schwefel, Tellur oder Gemische der Verbindungen Schwefel, Selen und/oder Tellur. Die erfindungsgemäße Selenverdampferkammer kann im Sinne der Erfindung analog auch als Verdampferkammer der Elemente Schwefel oder Tellur verwendet werden.

Die Erfindung umfasst bevorzugt die Verwendung der erfindungsgemäßen Vorrichtung zum diskontinuierlichen Nachfüllen einer Selenverdampferkammer, bei der Herstellung von Dünnschichtsolarzellen.

Im Folgenden wird die Erfindung anhand von Zeichnungen näher erläutert. Die Zeichnungen sind rein schematische Darstellungen und nicht maßstabsgetreu. Die Zeichnungen schränken die Erfindung in keiner Weise ein.

Es zeigen:
Figur 1 einen Querschnitt einer bevorzugten Ausführungsform der erfindungsgemäßen Vorrichtung,
Figur 1a eine Zwangsfördervorrichtung für Selen (12),
Figur 2 ein Schema der Kühlvorrichtung/Heizvorrichtung (16/17) im geschlossenen Zustand,
Figur 3 ein Schema der einzelnen Komponenten der Kühlvorrichtung/Heizvorrichtung (16/17) und
Figur 4 ein Fliesschema einer bevorzugten Ausführungsform des erfindungsgemäßen Verfahrens.

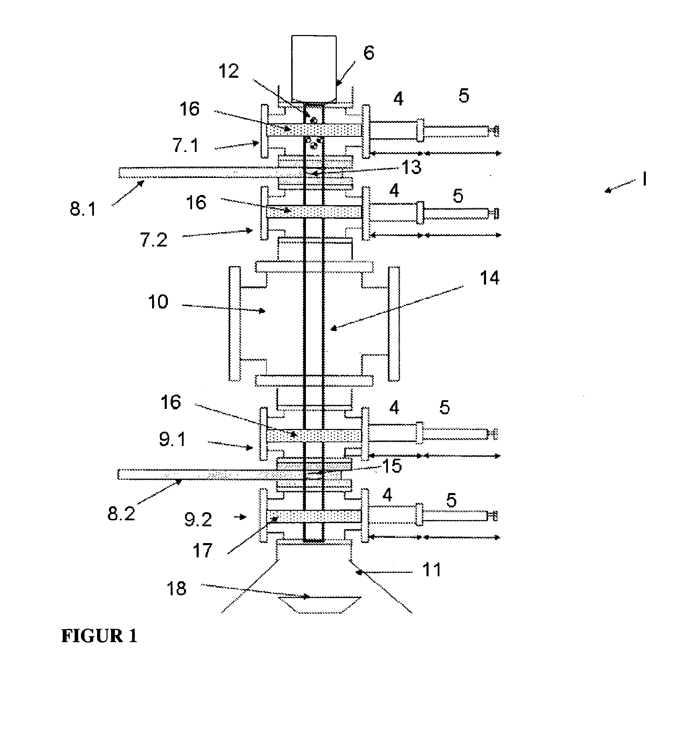

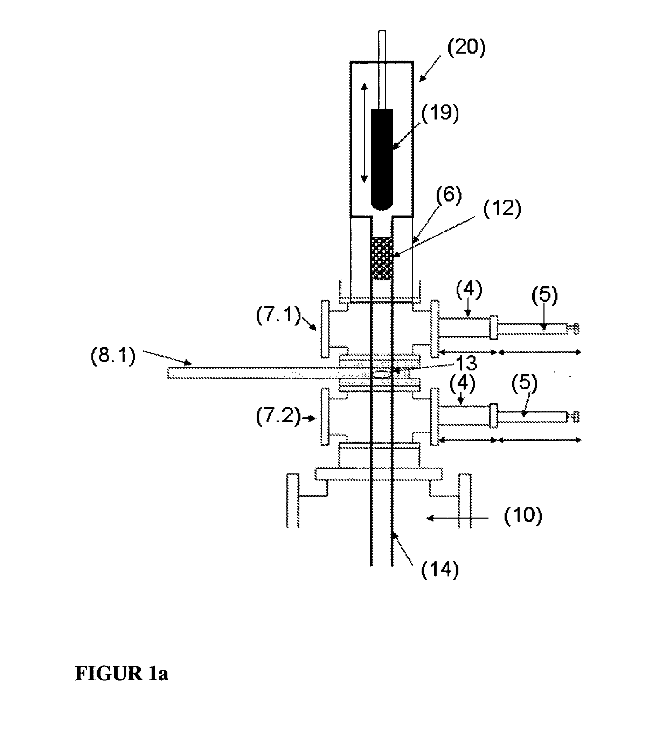

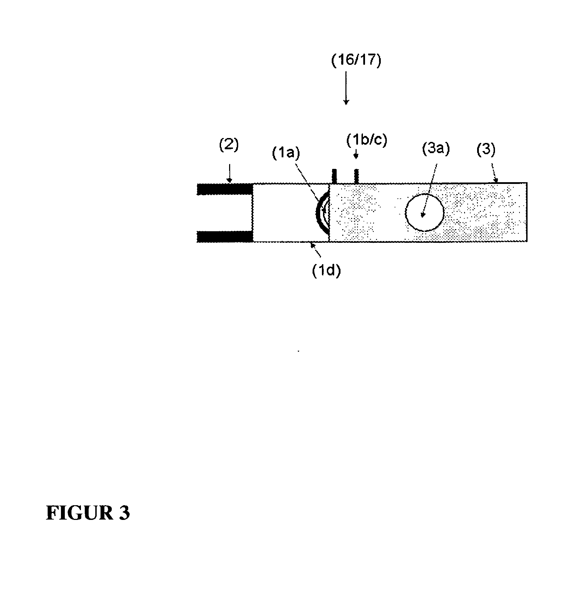

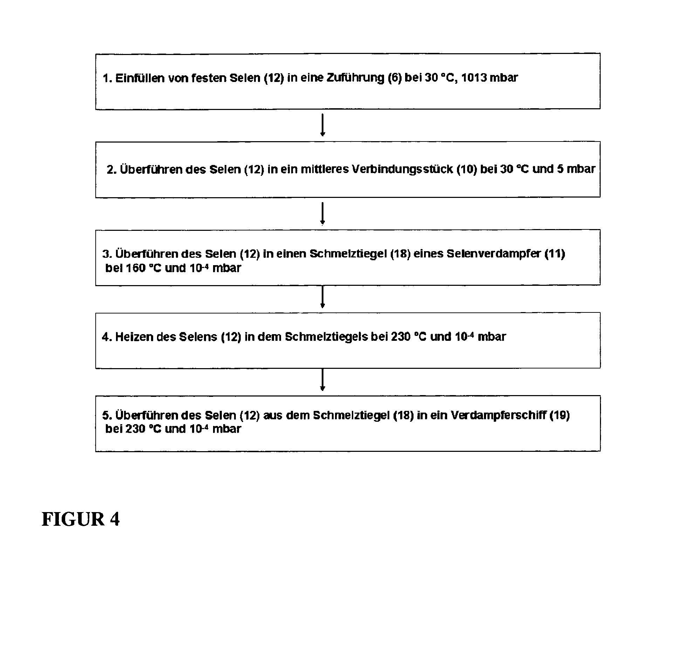

Figur 1 zeigt einen Querschnitt durch eine bevorzugte Ausführungsform der erfindungsgemäßen Vorrichtung (I). Selen (12) wird über die Zuführung (6) in die erfindungsgemäße Vorrichtung (I) eingefüllt und über den zylindrischen Hohlraum (14) zur Selenverdampferkammer (11) befördert. Um das Vakuum in der Selenverdampferkammer (11) nicht zu beeinflussen, erfolgt die Zugabe des Selens (12) zur Selenverdampferkammer (11) über zwei Vakuumschieber (8.1/8.2). Die erfindungsgemäße Vorrichtung (I) umfasst nach der Zuführung (6) ein erstes gekühltes Verbindungsstück (7.1), einen gekühlten Vakuumschieber (8.1) mit einer Öffnung (13) im gekühlten Vakuumschieber (8.1) und ein zweites gekühltes Verbindungsstück (7.2). Die Verbindungsstücke liegen als Kreutzstücke in den Abmessungen 210 mm x 210 mm vor. Das erste gekühlte Verbindungsstück (7.1) und das zweite gekühlte Verbindungsstück (7.2) enthalten ein Schiebergehäuse (4) in einer Länge von 75 mm sowie einen Schieber (5) in einer Länge von 105 mm. Der Schieber (5) kann auf einer Länge von 50 mm innerhalb des Schiebergehäuses (4) verschoben werden. Der Schieber (5) kann sowohl die Durchlässigkeit für Selen (12) als auch den Druck innerhalb der Vorrichtung (I) regulieren. So kann durch gezieltes Öffnen oder Schließen der Schieber (5) und die damit verbundene Kühlvorrichtung (16), die einzelnen Abschnitte der Vorrichtung (I) evakuiert oder belüftet werden. So kann die Vorrichtung evakuiert werden, wenn das erste gekühlte Verbindungsstück (7.1) gegenüber der Atmosphäre geschlossen ist und der gekühlte Vakuumschieber (8.1) und das zweite gekühlte Verbindungsstück (7.2) zur Selenverdampferkammer (11) hin geöffnet sind. Die Funktionsweise der Kühlvorrichtung (16) wird in Figur 3 und Figur 4 erläutert. Die beiden gekühlten Verbindungsstücke (7.1/7.2) regeln oder sperren die Durchlässigkeit des Selens (12) und temperieren über die Kühlvorrichtung (16) auch den gekühlten Vakuumschieber (8.1). Nach Passieren des zweiten gekühlten Verbindungsstücks (7.2) gelangt das Selen (12) über die Anordnung aus mittleren Verbindungsstück (10), dritten gekühlten Verbindungsstück (9.1), geheizter Vakuumschieber (8.2) mit Öffnung (15), erstes geheiztes Verbindungsstück (9.2) in die Selenverdampferkammer (11). Die beiden gekühlten/geheizten Verbindungsstücke (9.1/9.2) regeln oder sperren die Durchlässigkeit des Selens (12) und schützen den geheizten Vakuumschieber (8.2) vor Beschädigung durch festes Selen von oben und kondensierenden Selendampf von unten. Die grundsätzliche Funktionsweise des ersten geheizten Verbindungsstücks (9.2) entspricht dem der oben beschriebenen, gekühlten Verbindungsstücke (7.1/7.2/9.1). Das dritte gekühlte Verbindungsstück (9.1) muss kalt sein, sonst verklebt hier das feste Selen (12). Die gekühlten/geheizten Vakuumschieber (8.1/8.2) schotten den Zwischenraum aus zweiten gekühlten Verbindungsstück (7.2), mittlerem Verbindungsstück (10) und dem dritten gekühlten Verbindungsstück (9.1) gegenüber dem Atmosphärendruck in der Zuführung (6) sowie dem Vakuum der Selenverdampferkammer (11) ab. Die gekühlten/geheizten Vakuumschieber (8.1/8.2) ermöglichen das Einschleusen des Selens (12) in die Selenverdampferkammer (11) ohne Störung des Vakuums in den Schmelztiegel (18) der Selenverdampferkammer (11).

Figur 1a zeigt eine an der Zuführung (6) angebrachte Zwangsfördervorrichtung für Selen (12). Diese enthält ein an der Zuführung (6) angebrachtes, abnehmbares Gewindestabgehäuse mit Aufhängung (20) und einen darin entlang der Pfeilrichtung beweglich montierten Gewindestab (19). Der Gewindestab (19) befördert Selen (12), bevorzugt in Form von Presslingen oder Kugeln über den zylindrischen Hohlraum (14) in das mittlere Verbindungsstück (10) und von dort wie in Figur 1 gezeigt in die Selenverdampferkammer (11). Das Gewindestabgehäuse mit Aufhängung (20) ist bevorzugt mit einer Kühlung versehen.

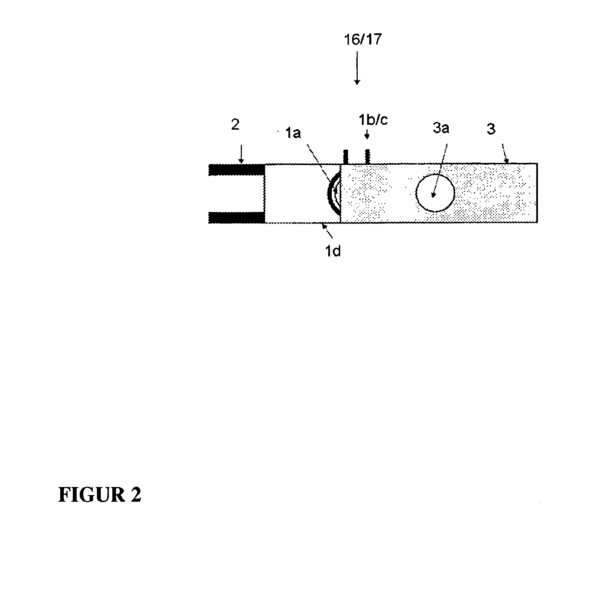

Figur 2 zeigt ein Schema der Kühlvorrichtung/Heizvorrichtung (16/17) im halb geschlossenen Zustand. Auf einem mechanischen Gegenlager (2) ist eine Lochplatte (1d) angeordnet. Die Öffnung der Lochplatte (1a) ist von einer Kühlung (1c) oder Heizung (1b) umgeben. Der Verschluss (3) mit der Öffnung im Verschluss (3a) regelt die Durchlässigkeit der Kühlvorrichtung/Heizvorrichtung (16/17) für das Selen (12). Sind die Öffnung der Lochplatte (1a) und die Öffnung im Verschluss (3a) deckungsgleich übereinander angeordnet, so ist die Kühlvorrichtung/Heizvorrichtung (16/17) durchlässig und entsprechend undurchlässig wenn der Verschluss (3) geschlossen über der Öffnung der Lochplatte (1a) liegt. Die Kühlvorrichtung (16) oder die Heizvorrichtung (17) ist wie in Figur 1 gezeigt, bevorzugt im 90° Winkel zum zylindrischen Hohlraum (14) angeordnet, wobei die Öffnung der Lochplatte (1a) sich direkt fixiert im zylindrischen Hohlraum (14) befindet oder ein Teil von diesem bildet. Die Position des Verschlusses (3) über der Lochplatte (1d) wird über die in Figur 1 beschriebene Anordnung aus Schieber (5) und Schiebergehäuse (4) geregelt. Der Schieber (5) ist bevorzugt direkt mit dem Verschluss (3) verbunden.

Figur 3 zeigt die in Figur 2 beschriebenen Komponenten mechanisches Gegenlager (2), Lochplatte (1d), Öffnung der Lochplatte (1a), Kühlung (1c) oder Heizung (1b), Verschluss (3) und die Öffnung im Verschluss (3a) der Kühlvorrichtung /Heizvorrichtung (16/17) im ausgebauten Zustand.

Figur 4 zeigt ein Fliesschema einer bevorzugten Ausführungsform des erfindungsgemäßen Verfahrens. Selen (12) wird über die Zuführung (6) in die erfindungsgemäße Vorrichtung (I) bei 30 °C und Atmosphärendruck (etwa 1013 mbar) in ein mittleres Verbindungsstück (10) bei 30 °C und 5 mbar Vakuum eingefüllt. Um ein Verkleben des Selens (12) zu vermeiden, erfolgt die Zugabe des Selens (12) bevorzugt über einen auf 30 °C temperierten, gekühlten Vakuumschieber (8.1). Die Funktionsweise des gekühlten Vakuumschiebers (8.1) erfolgt bevorzugt wie in Figur 1 erläutert. Die beiden gekühlten Verbindungsstücke (7.1/7.2) temperieren über die Kühlvorrichtungen (16) den gekühlten Vakuumschieber (8.1) und regulieren das Vakuum in der erfindungsgemäßen Vorrichtung (I). Anschließend gelangt das Selen (12) über die Anordnung aus mittlerem Verbindungsstück (10), geheizten Vakuumschiebers (8.2), in den Schmelztiegel (18) einer Selenverdampferkammer (11). Der geheizte Vakuumschieber (8.2) wird bei etwa 10⁻⁴ mbar auf etwa 160 °C erwärmt um ein Kondensieren der Selendämpfe aus der Selenverdampferkammer (11) zu vermeiden. Die Funktionsweise des geheizten Vakuumschiebers (8.2) erfolgt bevorzugt wie in Figur 1 erläutert. Das dritte gekühlte Verbindungsstück (9.1) und das erste geheizte Verbindungsstück (9.2) temperieren über die Kühl-/Heizvorrichtungen (16/17) den geheizten Vakuumschieber (8.2). Das im Schmelztiegel (18) befindliche Selen (12) wird bei 10⁻⁴ mbar auf etwa 230 °C erwärmt und verflüssigt in ein Verdampferschiff überführt. Das Verdampferschiff enthält bevorzugt Graphit und ermöglicht in Verbindung mit dem erfindungsgemäßen Verfahren eine diskontinuierliche Selenverdampfung.

### Beispiel

Die diskontinuierliche Selen-Nachfüllung kann beispielhaft wie folgt erfolgen.
1. Einfüllen vom festen Selen (12) in eine Zuführung (6) (1 atm, 30°C, 300 g, alle 5 min).
2. Belüften des mittleren Verbindungsstücks (10), zweiten gekühlten Verbindungsstücks (7.2) und dritten gekühlten Verbindungsstücks ( 9.1 ) von 10⁻⁴ mbar auf 1 atm.
3. Öffnen des gekühlten Vakuumschiebers (8.1) und des (mechanischen) Schiebers (5) im gekühlten Verbindungsstück (7.2).
4. Öffnen des Schiebers (5) im gekühlten Verbindungsstück (7.1) und Fallen des festen Selens (12) durch den gekühlten Vakuumschieber (8.1), durch das zweite gekühlte Verbindungsstück (7.2) und durch das mittlere Verbindungsstück (10) auf den Schieber (5) im gekühlten Verbindungsstück (9.1) (1 atm, 30°C, jeweils 300 g, alle 5 min).
5. Schließen des Schiebers (5) im gekühlten Verbindungsstück (7.1), des gekühlten Vakuumschiebers (8.1) und des Schiebers (5) im zweiten gekühlten Verbindungsstück (7.2).
6. Abpumpen des mittleren Verbindungsstücks (10), zweiten gekühlten Verbindungsstücks (7.2) und dritten gekühlten Verbindungsstücks ( 9.1 ) mit dem festen Selen (12) von 1 atm auf 10⁻⁴ mbar.
7. Öffnen des geheizten Vakuumschiebers ( 8.2 ) und des Schiebers (5) im ersten geheizten Verbindungsstück ( 9.2 ).
8. Öffnen des Schiebers (5) im dritten gekühlten Verbindungsstück (9.1) und Fallen des festen Selens (12) (jeweils 300 g, alle 5 min) durch den geheizten Vakuumschieber ( 8.2 ) und durch das erste auf 160°C geheizte Verbindungsstück ( 9.2 ) in den Schmelztiegel (18) bei 230°C und 10⁻⁴ mbar.
9. Heizen des festen Selens (12) im Schmelztiegel (18) bis es bei 230°C und 10⁻⁴ mbar schmilzt.
10. Das flüssige Selen (12) fließt kontinuierlich vom Schmelztiegel (18) in das Verdampferschiff der Selenverdampferkammer (11) bei 10⁻⁴ mbar und 230°C.

### Es zeigen:

- (1a): Öffnung in der Lochplatte,
- (1b): Heizung,
- (1c): Kühlung,
- (1d): Lochplatte,
- (2): Mechanisches Gegenlager,
- (3): Verschluss,
- (3a): Öffnung im Verschluss
- (4): Schiebergehäuse,
- (5): Schieber,
- (6): Zuführung für festes Selen,
- (7.1): erstes gekühltes Verbindungsstück,
- (7.2): zweites gekühltes Verbindungsstück,
- (8.1): gekühlter Vakuumschieber,
- (8.2): geheizter Vakuumschieber,
- (9.1): drittes gekühltes Verbindungsstück,
- (9.2): erstes geheiztes Verbindungsstück,
- (10): mittleres Verbindungsstück,
- (11): Selenverdampferkammer,
- (12): Selen,
- (13): Öffnung im gekühlten Vakuumschieber,
- (14): zylindrischer Hohlraum,
- (15): Öffnung im geheizten Vakuumschieber,
- (16): Kühlvorrichtung,
- (17): Heizvorrichtung,
- (18): Schmelztiegel,
- (19): Gewindestab und
- (20): Gewindestabgehäuse mit Aufhängung.

## Patentansprüche

1. Verfahren zum diskontinuierlichen Nachfüllen einer Selenverdampferkammer, wobei
a. Selen (12) über eine Zuführung (6) durch Öffnen eines gekühlten Vakuumschiebers (8.1) in ein mittleres Verbindungsstück (10) eingeführt wird, wobei der gekühlte Vakuumschieber (8.1) auf 20 °C bis 45 °C temperiert wird,
b. der gekühlte Vakuumschieber (8.1) geschlossen wird,
c. ein Vakuum zwischen dem gekühlten Vakuumschieber (8.1), dem mittleren Verbindungsstück (10) und einem geheizten Vakuumschieber (8.2) angelegt wird, wobei der geheizte Vakuumschieber (8.2) auf 130 °C bis 180 °C temperiert wird,
d. das Selen (12) in eine Selenverdampferkammer (11) durch Öffnen des geheizten Vakuumschiebers (8.2) überführt wird und
e. der geheizte Vakuumschieber (8.2) geschlossen wird.

2. Verfahren nach Anspruch 1, wobei die Kühlung des gekühlten Vakuumschiebers (8.1) durch ein angebrachtes erstes gekühltes Verbindungsstück (7.1) und/oder ein zweites gekühltes Verbindungsstück (7.2) erfolgt.

3. Verfahren nach Anspruch 1 oder 2, wobei die Temperierung des geheizten Vakuumschiebers (8.2) durch ein angebrachtes drittes gekühltes Verbindungsstück (9.1) und/oder ein erstes geheiztes Verbindungsstück (9.2) erfolgt.

4. Verfahren nach einem der Ansprüche 1 bis 3, wobei der gekühlte Vakuumschieber (8.1) auf 25 °C bis 35 °C temperiert wird.

5. Verfahren nach einem der Ansprüche 1 bis 4, wobei der geheizte Vakuumschieber (8.2) auf 150 °C bis 170°C temperiert wird.

6. Vorrichtung zum diskontinuierlichen Nachfüllen einer Selenverdampferkammer umfassend:
a. eine Zuführung (6) für festes Selen (12),
b. ein an der Zuführung (6) befestigter, gekühlter Vakuumschieber (8.1),
c. ein an dem gekühlten Vakuumschieber (8.1) angebrachtes, mittleres Verbindungsstück (10),
d. ein an dem mittleren Verbindungsstück (10) angebrachter, geheizter Vakuumschieber (8.2) und
e. eine an dem geheizten Vakuumschieber (8.2) angebrachte Selenverdampferkammer (11).

7. Vorrichtung nach Anspruch 6, wobei unterhalb dem gekühlten Vakuumschieber (8.1)
a. ein erstes gekühltes Verbindungsstück (7.1) angebracht ist und unterhalb des gekühlten Vakuumschiebers (8.1) ein zweites gekühltes Verbindungsstück (7.2) angebracht ist und wobei oberhalb des beheizten Vakuumschiebers (8.2) ein drittes gekühltes Verbindungsstück (9.1) angebracht ist und unterhalb des beheizten Vakuumschiebers (8.2) ein erstes geheiztes Verbindungsstück (9.2) angebracht ist.

8. Vorrichtung nach Anspruch 7, wobei das erste gekühlte Verbindungsstück (7.1), das zweite gekühlte Verbindungsstück (7.2) und/oder das dritte gekühlte Verbindungsstück (9.1) eine Lochplatte (1 d) mit einer Öffnung (1 a) und eine Kühlung (1c), ein mechanisches Gegenlager (2), einen Verschluss (3), einen Schieber (5) und/oder ein Schiebergehäuse (4) enthalten.

9. Vorrichtung nach einem der Ansprüche 6 bis 8, wobei das erste geheizte Verbindungsstück (9.2) eine Lochplatte (1d) mit einer Öffnung (1a) und einer Heizung (1b), ein mechanisches Gegenlager (2), einen Verschluss (3) einen Schieber (5) und ein Schiebergehäuse (4) enthält.

10. Vorrichtung nach einem der Ansprüche 6 bis 9, wobei die Zuführung (6), das mittlere Verbindungsstück (10), das erste gekühlte Verbindungsstück (7.1), das zweite gekühlte Verbindungsstück (7.2), das dritte gekühlte Verbindungsstück (9.1) und/oder das erste geheizte Verbindungsstück (9.2) einen durchgängigen zylindrischen Hohlraum (14) mit einem Durchmesser von 20 mm bis 50 mm aufweisen.

11. Vorrichtung nach einem der Ansprüche 6 bis 10, wobei das mittlere Verbindungsstück (10), das erste gekühlte Verbindungsstück (7.1), das zweite gekühlte Verbindungsstück (7.2), das dritte gekühlte Verbindungsstück (9.1) und/oder das erste geheizte Verbindungsstück (9.2) Kreutzstücke umfassen.

12. Vorrichtung nach einem der Ansprüche 6 bis 11, wobei das mittlere Verbindungsstück (10), das erste gekühlte Verbindungsstück (7.1), das zweite gekühlte Verbindungsstück (7.2), das dritte gekühlte Verbindungsstück (9.1) und/oder das erste geheizte Verbindungsstück (9.2) eine Breite und/oder Höhe von 150 mm bis 300 mm, bevorzugt 200 mm bis 250 mm aufweisen.

13. Vorrichtung nach einem der Ansprüche 6 bis 12, wobei der geheizte Vakuumschieber (8.2) und/oder gekühlte Vakuumschieber (8.1) eine Öffnung (13/15) mit einem Durchmesser von 15 mm bis 50 mm, bevorzugt 30 mm bis 40 mm aufweisen.

14. Vorrichtung nach einem der Ansprüche 6 bis 13, wobei die Öffnung (1a) von einer Heizung (1b) oder Kühlung (1c) umgeben ist.

15. Verwendung der Vorrichtung nach einem der Ansprüche 6 bis 14 zum diskontinuierlichen Nachfüllen einer Verdampferkammer für Schwefel, Selen, Tellur und/oder Gemischen davon, bevorzugt zum diskontinuierlichen Nachfüllen einer Selenverdampferkammer, bei der Herstellung von Dünnschichtsolarzellen.

## Claims

1. Method for discontinuously refilling a selenium evaporator chamber, wherein
a. selenium (12) is introduced into a central connection piece (10) via a feeder (6) by opening a cooled vacuum slide (8.1), wherein the cooled vacuum slide (8.1) is maintained at 20 °C to 45 °C,
b. the cooled vacuum slide (8.1) is closed,
c. a vacuum is applied between the cooled vacuum slide (8.1), the central connection piece (10), and a heated vacuum slide (8.2), wherein the heated vacuum slide (8.2) is maintained at 130 °C to 180 °C,
d. the selenium (12) is transferred into a selenium evaporator chamber (11) by opening the heated vacuum slide (8.2), and
e. the heated vacuum slide (8.2) is closed.

2. Method according to claim 1, wherein the cooling of the cooled vacuum slide (8.1) takes place by means of an installed first cooled connection piece (7.1) and/or a second cooled connection piece (7.2).

3. Method according to claim 1 or 2, wherein the temperature regulation of the heated vacuum slide (8.2) takes place by means of an installed third cooled connection piece (9.1) and/or a first heated connection piece (9.2).

4. Method according to one of claims 1 through 3, wherein the cooled vacuum slide (8.1) is maintained at 25 °C to 35 °C.

5. Method according to one of claims 1 through 4, wherein the heated vacuum slide (8.2) is maintained at 150 °C to 170 °C.

6. Device for discontinuously refilling a selenium evaporator chamber comprising:
a. a feeder (6) for solid selenium (12),
b. a cooled vacuum slide (8.1) affixed on the feeder (6),
c. a central connection piece (10) installed on the cooled vacuum slide (8.1),
d. a heated vacuum slide (8.2) installed on the central connection piece (10), and
e. a selenium evaporator chamber (11) installed on the heated vacuum slide (8.2).

7. Device according to claim 6, wherein below the cooled vacuum slide (8.1)
a. a first cooled connection piece (7.1) is installed, and below the cooled vacuum slide (8.1) a second cooled connection piece (7.2) is installed and wherein above the heated vacuum slide (8.2) a third cooled connection piece (9.1) is installed, and below the heated vacuum slide (8.2) a first heated connection piece (9.2) is installed.

8. Device according to claim 7, wherein the first cooled connection piece (7.1), the second cooled connection piece (7.2), and/or the third cooled connection piece (9.1) include a perforated plate (1 d) with an opening (1a) and a cooler (1c), a mechanical counter-bearing (2), a closure (3), a slide (5), and/or a slide housing (4).

9. Device according to one of claims 6 through 8, wherein the first heated connection piece (9.2) includes a perforated plate (1d) with an opening (1a) and a heater (1b), a mechanical counter-bearing (2), a closure (3), a slide (5), and a slide housing (4).

10. Device according to one of claims 6 through 9, wherein the feeder (6), the central connection piece (10), the first cooled connection piece (7.1), the second cooled connection piece (7.2), the third cooled connection piece (9.1), and/or the first heated connection piece (9.2) have a continuous cylindrical cavity (14) with a diameter of 20 mm to 50 mm.

11. Device according to one of claims 6 through 10, wherein the central connection piece (10), the first cooled connection piece (7.1), the second cooled connection piece (7.2), the third cooled connection piece (9.1), and/or the first heated connection piece (9.2) comprise cross fittings.

12. Device according to one of claims 6 through 11, wherein the central connection piece (10), the first cooled connection piece (7.1), the second cooled connection piece (7.2), the third cooled connection piece (9.1), and/or the first heated connection piece (9.2) have a width and/or height of 150 mm to 300 mm, preferably 200 mm to 250 mm.

13. Device according to one of claims 6 through 12, wherein the heated vacuum slide (8.2) and/or cooled vacuum slide (8.1) have an opening (13/15) with a diameter of 15 mm to 50 mm, preferably 30 mm to 40 mm.

14. Device according to one of claims 6 through 13, wherein the opening (1a) is surrounded by a heater (1b) or cooler (1c).

15. Use of the device according to one of claims 6 through 14 for discontinuously refilling an evaporator chamber for sulfur, selenium, tellurium, and/or mixtures thereof, preferably for discontinuously refilling a selenium evaporator chamber, during the production of thin-film solar cells.

## Revendications

1. Procédé de rechargement discontinu d'une chambre d'évaporateur de sélénium (9), dans lequel :
a. du sélénium (12) est introduit par une alimentation (6), en ouvrant un registre pour vide refroidi (8.1), dans une pièce centrale de liaison (10), le registre pour vide refroidi (8.1) étant conditionné thermiquement à une température de 20°C à 45°C ;
b. le registre pour vide refroidi (8.1) est refermé ;
c. un vide est créé entre le registre pour vide refroidi (8.1), la pièce centrale de liaison (10) et un registre pour vide chauffé (8.2), le registre pour vide chauffé (8.2) étant conditionné thermiquement à une température de 130°C à 180°C ;
d. le sélénium (12) est transvasé dans une chambre de l'évaporateur de sélénium (11) en ouvrant le registre pour vide chauffé (8.2) ; et
e. le registre pour vide chauffé (8.2) est refermé.

2. Procédé selon la revendication 1, dans lequel le refroidissement du registre pour vide refroidi (8.1) est assuré par une première pièce de liaison refroidie (7.1) appliquée et/ou une deuxième pièce de liaison refroidie (7.2).

3. Procédé selon l'une des revendications 1 ou 2, dans lequel le conditionnement thermique du registre pour vide chauffé (8.2) est assuré par une troisième pièce de liaison refroidie (9.1) appliquée et/ou une première pièce de liaison chauffée (9.2).

4. Procédé selon l'une des revendications 1 à 3, dans lequel le registre pour vide refroidi (8.1) est conditionné thermiquement à une température de 25°C à 35°C.

5. Procédé selon l'une des revendications 1 à 4, dans lequel le registre pour vide chauffé (8.2) est conditionné thermiquement à une température de 150°C à 170°C.

6. Dispositif pour le rechargement discontinu d'une chambre d'évaporateur de sélénium, comprenant :
a. une alimentation (6) pour sélénium solide (12) ;
b. un registre pour vide refroidi (8.1) fixé à l'alimentation (6) ;
c. une pièce centrale de liaison (10) adjacente au registre pour vide refroidi (8.1) :
d. un registre pour vide chauffé (8.2) adjacent à la pièce centrale de liaison (10) ; et
e. une chambre de l'évaporateur de sélénium (11) adjacente au registre pour vide chauffé (8.2).

7. Dispositif selon la revendication 6, dans lequel sont placées au-dessous du registre pour vide refroidi (8.1)
a. une première pièce de liaison refroidie (7.1) et au-dessous du registre pour vide refroidi (8.1) une deuxième pièce de liaison refroidie (7.2) et dans lequel sont placées au-dessus du registre pour vide chauffé (8.2) une troisième pièce de liaison refroidie (9.1) et au-dessous du registre pour vide chauffé (8.2) une première pièce de liaison chauffée (9.2).

8. Dispositif selon la revendication 7, dans lequel la première pièce de liaison refroidie (7.1), la deuxième pièce de liaison refroidie (7.2) et/ou la troisième pièce de liaison refroidie (9.1) comportent une plaque perforée (1d) avec une ouverture (1a) et un refroidisseur (1c), une butée mécanique (2), une fermeture (3), un registre (5) et/ou un carter de registre (4).

9. Dispositif selon l'une des revendications 6 à 8, dans lequel la première pièce de liaison chauffée (9.2) comporte une plaque perforée (1d) avec une ouverture (1a) et un chauffage (1b), une butée mécanique (2), une fermeture (3), un registre (5) et un carter de registre (4).

10. Dispositif selon l'une des revendications 6 à 9, dans lequel l'alimentation (6), la pièce centrale de liaison (10), la première pièce de liaison refroidie (7.1), la deuxième pièce de liaison refroidie (7.2), la troisième pièce de liaison refroidie (9.1) et/ou la première pièce de liaison chauffée (9.2) possèdent un espace cylindrique intérieur traversant (14) présentant un diamètre de 20 mm à 50 mm.

11. Dispositif selon l'une des revendications 6 à 10, dans lequel la pièce centrale de liaison (10), la première pièce de liaison refroidie (7.1), la deuxième pièce de liaison refroidie (7.2), la troisième pièce de liaison refroidie (9.1) et/ou la première pièce de liaison chauffée (9.2) comprennent des pièces en croix.

12. Dispositif selon l'une des revendications 6 à 11, dans lequel la pièce centrale de liaison (10), la première pièce de liaison refroidie (7.1), la deuxième pièce de liaison refroidie (7.2), la troisième pièce de liaison refroidie (9.1) et/ou la première pièce de liaison chauffée (9.2) présentent une largeur et/ou une hauteur de 150 mm à 300 mm, de préférence de 200 mm à 250 mm.

13. Dispositif selon l'une des revendications 6 à 12, dans lequel le registre pour vide chauffé (8.2) et/ou le registre pour vide refroidi (8.1) possèdent une ouverture (13, 15) d'un diamètre de 15 mm à 50 mm, de préférence de 30 mm à 40 mm.

14. Dispositif selon l'une des revendications 6 à 13, dans lequel l'ouverture (1a) est entourée par un chauffage (1b) ou un refroidisseur (1c).

15. Utilisation du dispositif selon l'une des revendications 6 à 14 pour le rechargement discontinu d'une chambre d'évaporateur pour soufre, sélénium, tellure et/ou mélanges de ceux-ci, de préférence pour le rechargement discontinu d'une chambre d'évaporateur de sélénium, dans la fabrication de cellules solaires à couches minces.
